# EUROPEAN PATENT SPECIFICATION

(11) **EP 4 451 418 B1**
(45) Date of publication and mention of the grant of the patent: **15.07.2026**
(21) Application number: 23812041.4
(22) Date of filing: 11.05.2023
(51) Int. Cl.: H01M 10/42, H01M 10/48, G01R 31/389, G01R 19/165, G01R 27/08

(54) **BATTERY MANAGEMENT APPARATUS AND OPERATION METHOD THEREOF**
BATTERIEVERWALTUNGSVORRICHTUNG UND BETRIEBSVERFAHREN DAFÜR
DISPOSITIF DE GESTION DE BATTERIE ET SON PROCÉDÉ DE FONCTIONNEMENT

(30) Priority: 25.05.2022 KR 20220064229
(43) Date of publication of application: 23.10.2024
(73) Proprietor: LG Energy Solution, Ltd., Seoul 07335 (KR)
(72) Inventor: SON, Dae Hee, Daejeon 34122 (KR); GIM, Deok Hwan, Daejeon 34122 (KR)
(74) Representative: Plasseraud IP
(86) International application number: PCT/KR2023/006433
(87) International publication number: WO 2023/229267

(56) References cited:
- KR-A- 20100 121 354
- KR-A- 20140 075 983
- KR-A- 20140 103 753
- KR-A- 20160 072 874
- KR-B1- 100 546 246
- US-A1- 2019 288 520
- US-A1- 2020 209 319
- US-A1- 2021 109 160

## Description

### [TECHNICAL FIELD]

### CROSS-REFERENCE TO RELATED APPLICATION

This application claims priority to and the benefit of Korean Patent Application No. 10-2022-0064229 filed in the Korean Intellectual Property Office on May 25, 2022.

### TECHNICAL FIELD

Embodiments disclosed herein relate to a battery management apparatus and an operating method thereof.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management apparatus (or a battery management system (BMS)) that monitors and controls temperature, voltage, and current of the battery is driven to diagnose the state of the battery.

However, a conventional battery management apparatus has a difficulty in detecting a battery cell where heat is generated inside a battery bank unless a thermistor is attached to each battery bank including a plurality of battery cells to measure a temperature.

The conventional battery management apparatus may detect a heat-generated battery cell inside the battery by measuring a direct current resistance (DCR) of each battery bank, but large equipment is used in measurement of the direct current resistance, such that measurement of the direct current resistance may be possible only when the battery bank is being charged and measurement may be impossible during the use of the battery bank, degrading effectiveness.
US2021109160A1 discloses a battery monitoring device, integrated circuit, and battery monitoring system. US2020209319A1 discloses a battery performance evaluation device, and battery performance evaluation method. US11070065B2 discloses a method and apparatus of a modular management system for energy storage cells.

### [DISCLOSURE]

### [TECHNICAL PROBLEM]

Embodiments disclosed herein aim to provide a battery management apparatus and an operating method thereof, that may determine whether an abnormal battery cell exists in a battery bank based on an impedance of a battery bank, obtained by measuring a current and a voltage of the battery bank.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to claim 1 includes a switch connected to a plurality of battery banks including a plurality of battery cells and a controller configured to apply a control signal for repeatedly turning on or off the switch, measuring a voltage value and a current value of each of the plurality of battery banks, and determine whether a plurality of battery cells included in each of the plurality of battery banks are abnormal based on an alternating current impedance of each of the plurality of battery banks calculated based on the voltage value and the current value.

According to an embodiment, the controller may be further configured to obtain a real value and an imaginary value of the voltage value and the current value by performing Fourier transform on the voltage value and the current value of each of the plurality of battery banks.

According to an embodiment, the controller may be further configured to obtain an imaginary value of an impedance of each of the plurality of battery banks based on the real value and the imaginary value of the voltage value and the current value.

According to an embodiment, the controller is further configured to determine that a heat-generated battery cell exists in at least any one of battery cells inside any one of the plurality of battery banks when an imaginary value of an impedance of any one of the plurality of battery banks exceeds a previously stored threshold value.

According to an embodiment, the controller may be further configured to determine that a heat-generated battery cell exists in at least any one of battery cells inside any one of the plurality of battery banks when an imaginary value of an impedance of any one of the plurality of battery banks falls beyond a threshold error range of an imaginary value of an impedance of a battery bank serially connected to any one of the plurality of battery banks.

An operating method of a battery management apparatus according to claim 5 includes applying a control signal for repeatedly turning on or off a switch connected to a plurality of battery banks including a plurality of battery cells, measuring a voltage value and a current value of each of the plurality of battery banks, calculating an alternating current impedance of each of the plurality of battery banks based on the voltage value and the current value, and determining whether a plurality of battery cells included in each of the plurality of battery banks are abnormal based on an alternating current impedance of each of the plurality of battery banks.

According to an embodiment, the calculating of the alternating current impedance of each of the plurality of battery banks based on the voltage value and the current value may include obtaining a real value and an imaginary value of the voltage value and the current value by performing Fourier transform on the voltage value and the current value of each of the plurality of battery banks.

According to an embodiment, the calculating of the alternating current impedance of each of the plurality of battery banks based on the voltage value and the current value may include obtaining an imaginary value of an impedance of each of the plurality of battery banks based on the real value and the imaginary value of the voltage value and the current value.

According to an embodiment, the determining of whether the plurality of battery cells included in each of the plurality of battery banks are abnormal based on an alternating current impedance of each of the plurality of battery banks may include determining that a heat-generated battery cell exists in at least any one of battery cells inside any one of the plurality of battery banks when an imaginary value of an impedance of any one of the plurality of battery banks exceeds a previously stored threshold value.

According to an embodiment, the determining of whether the plurality of battery cells included in each of the plurality of battery banks are abnormal based on an alternating current impedance of each of the plurality of battery banks may include determining that a heat-generated battery cell exists in at least any one of battery cells inside any one of the plurality of battery banks when an imaginary value of an impedance of any one of the plurality of battery banks falls beyond a threshold error range of an imaginary value of an impedance of a battery bank serially connected to any one of the plurality of battery banks.

### [ADVANTAGEOUS EFFECTS]

With the battery management apparatus and the operating method thereof according to an embodiment disclosed herein, it may be determined whether an abnormal battery cell exists inside a battery bank based on an impedance of the battery bank measured by a current and a voltage of the battery bank.

### [DESCRIPTION OF DRAWINGS]

FIG. 1 illustrates a battery pack according to an embodiment disclosed herein.
FIG. 2 is a circuit diagram illustrating an implementation example of a battery management apparatus according to an embodiment disclosed herein.
FIG. 3 is a graph showing a change in a current value and a voltage value of a battery bank with respect to a flow of a time frequency, according to an embodiment disclosed herein.
FIG. 4A is a graph showing a result of Fourier transform of a current value of a battery bank with respect to a flow of a time frequency, according to an embodiment disclosed herein.
FIG. 4B is a graph showing a result of Fourier transform of a voltage value of a battery bank with respect to a flow of a time frequency, according to an embodiment disclosed herein.
FIG. 4C is a graph showing a real value and an imaginary value of an impedance of a battery bank with respect to a flow of a time frequency, according to an embodiment disclosed herein.
FIG. 5 is a graph showing a change in an imaginary value of an impedance a battery bank with respect to a change in a time frequency, according to an embodiment disclosed herein.
FIG. 6 is a flowchart showing an operating method of a battery management apparatus, according to an embodiment disclosed herein.

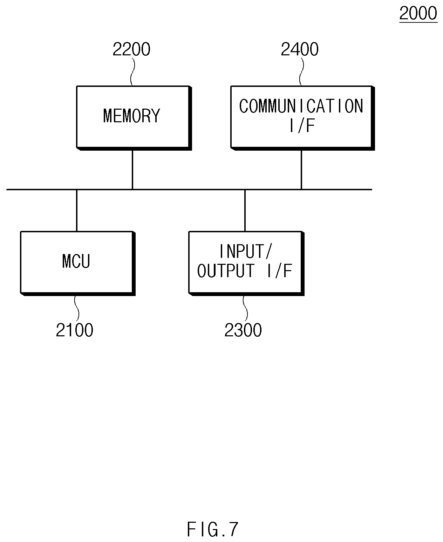

FIG. 7 is a block diagram showing a hardware configuration of a computing system for implementing a battery management apparatus according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

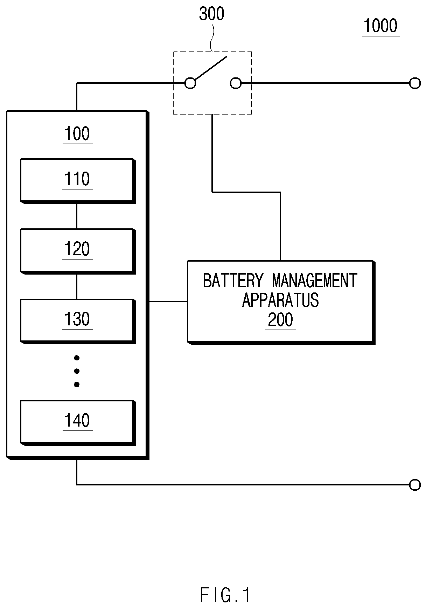

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300.

The battery module 100 may include a plurality of battery banks 110, 120, 130, and 140. Although the plurality of battery banks are illustrated as four in FIG. 1, the present disclosure is not limited thereto, and the battery module 100 may include n battery banks (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery banks 110, 120, 130, and 140, and the target device may be, for example, an electric vehicle (EV) or an energy storage system (ESS), but is not limited thereto.

The plurality of battery banks 110, 120, 130, and 140 may include a plurality of battery cells. The battery cell, which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. According to an embodiment, the plurality of battery cells included in each of the plurality of battery banks 110, 120, 130, and 140 may be connected in parallel to each other.

Meanwhile, although one battery module 100 is illustrated in FIG. 1, the battery module 100 may be configured in plural according to an embodiment.

The battery management apparatus (a battery management system (BMS)) 200 may predict a life (a state of health (SoH)) of the plurality of battery banks 110, 120, 130, and 140 based on temperature and voltage data of the plurality of battery banks 110, 120, 130, and 140. The battery management apparatus 200 may remove noise from battery data of the plurality of battery banks 110, 120, 130, and 140 and predict a life (SoH) of the plurality of battery banks 110, 120, 130, and 140 for each of temperature and charge/discharge rate of a battery based on the noise-removed data.

The battery management apparatus 200 may manage and/or control a state and/or an operation of the battery module 100. For example, the battery management apparatus 200 may manage and/or control the states and/or operations of the plurality of battery banks 110, 120, 130, and 140 included in the battery module 100. The battery management apparatus 200 may manage charging and/or discharging of the battery module 100.

In addition, the battery management apparatus 200 may monitor a voltage, a current, a temperature, etc., of the battery module 100 and/or each of the plurality of battery banks 110, 120, 130, and 140 included in the battery module 100. A sensor or various measurement modules for monitoring performed by the battery management system, which are not shown, may be additionally installed in the battery module 100, a charging/discharging path, any position of the battery module 100, etc. The battery management apparatus 200 may calculate a parameter indicating a state of the battery module 100, e.g., a state of charge (SoC), a SoH, etc., based on a measurement value such as monitored voltage, current, temperature, etc.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

The battery management apparatus 200 may calculate a cell balancing time of each of the plurality of battery banks 110, 120, 130, and 140. Herein, the cell balancing time may be defined as a time required for balancing of the battery cell. For example, the battery management apparatus 200 may calculate a cell balancing time based on an SoC, a battery capacity, and a balancing efficiency of each of the plurality of battery banks 110, 120, 130, and 140.

For the plurality of battery banks 110, 120, 130, and 140, as a period of use or the number of times of use increases, a capacity may decrease, internal resistance may increase, and various factors of the battery may change. The battery management apparatus 200 may calculate an impedance of a battery bank based on data of various factors changing with deterioration of the battery.

More specifically, the battery management apparatus 200 may calculate an imaginary value of an impedance of the plurality of battery banks 110, 120, 130, and 140 based on data of various factors changing with deterioration of the plurality of battery banks 110, 120, 130, and 140 to determine whether an abnormal battery cell exists inside the plurality of battery banks 110, 120, 130, and 140.

The imaginary value of the impedance of the battery may be an index indicating whether heat is generated in the battery in an abnormal state when compared to a normal state of the battery bank. The imaginary value of the impedance of the normal battery bank and the imaginary value of the impedance of the abnormal battery bank may be distinguished.

For example, the battery management apparatus 200 may determine whether an abnormal battery cell exists inside the plurality of battery banks 110, 120, 130, and 140 based on a voltage and a current of each of the plurality of battery banks 110, 120, 130, and 140.

Hereinbelow, a configuration and an operation of the battery management apparatus 200 will be described in detail.

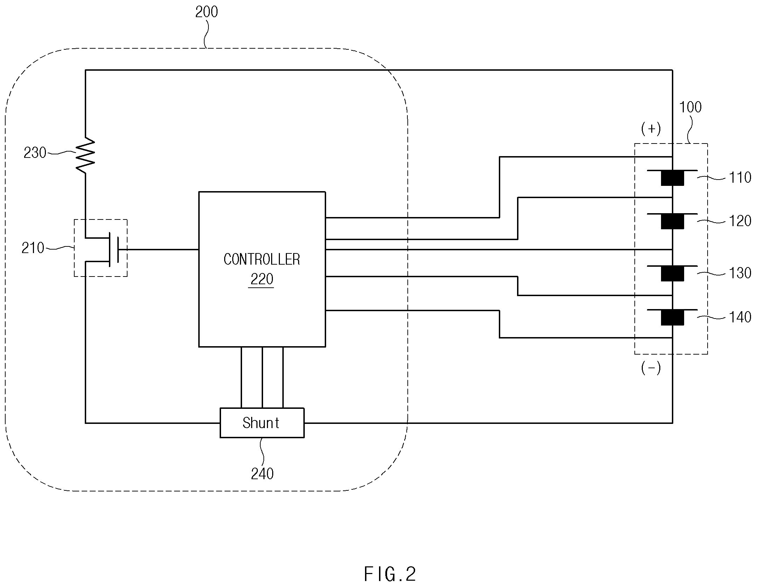

FIG. 2 is a circuit diagram illustrating an implementation example of a battery management apparatus according to an embodiment disclosed herein.

Referring to FIG. 2, the battery management apparatus 200 may include a switch 210, a controller 220, a first resistor 230, and a shunt resistor 240.

The switch 210 may be connected to a plurality of battery banks including a plurality of battery cells. The switch 210 may include, for example, a field effect transistor (FET). The switch 210 may receive a control signal for repeatedly turning on and off the switch 210 from the controller 220. The switch 210 may be repeatedly turned on or off based on the control signal received from the controller 220. The switch 210 may be repeatedly turned on or off and deliver a current in an alternating current waveform to the plurality of battery banks 110, 120, 130, and 140.

The first resistor 230 may control a flow of current inside the battery management apparatus 200 to allow an internal circuit of the battery management apparatus 200 to smoothly operate.

The controller 220 may determine whether an abnormal battery cell exists inside the plurality of battery banks 110, 120, 130, and 140 based on battery data of the plurality of battery banks 110, 120, 130, and 140. More specifically, the controller 220 may determine whether a heat-generated battery cell exists inside the plurality of battery banks 110, 120, 130, and 140 based on battery data of the plurality of battery banks 110, 120, 130, and 140.

The controller 220 may generate the control signal for repeatedly turning on and off the switch 210 and apply the control signal to the switch 210. The controller 220 may measure a voltage value and a current value of each of the plurality of battery banks 110, 120, 130, and 140 having received the current in the alternating current waveform based on a switching operation of the switch 210.

More specifically, the controller 220 may measure a current value of each of the plurality of battery banks 110, 120, 130, and 140 by using the shunt resistor 240. Herein, the shunt resistor 240 may be a resistor mainly used for current measurement as a shunt resistor and may have a very low resistance value. The shunt resistor 240 may measure a current value of each of the plurality of battery banks 110, 120, 130, and 140, and the controller 220 may obtain a current value of each of the plurality of battery banks 110, 120, 130, and 140 from the shunt resistor 240.

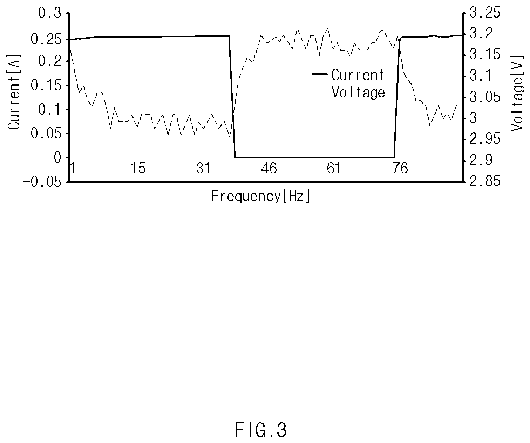

FIG. 3 is a graph showing a change in a current value and a voltage value of a battery bank with respect to a flow of a time frequency, according to an embodiment disclosed herein.

Referring to FIG. 3, current of each of the plurality of battery banks 110, 120, 130, and 140 having received a current in the alternating current waveform may be measured in the form of a square wave based on the control signal of the controller 220. A measured waveform of a voltage value of each of the plurality of battery banks 110, 120, 130, and 140 over time may shake.

The controller 220 may determine whether a plurality of battery cells included in each of the plurality of battery banks 110, 120, 130, and 140 are abnormal, based on an alternating current impedance of each of the plurality of battery banks 110, 120, 130, and 140 calculated based on a voltage value and a current value of each of the plurality of battery banks 110, 120, 130, and 140.

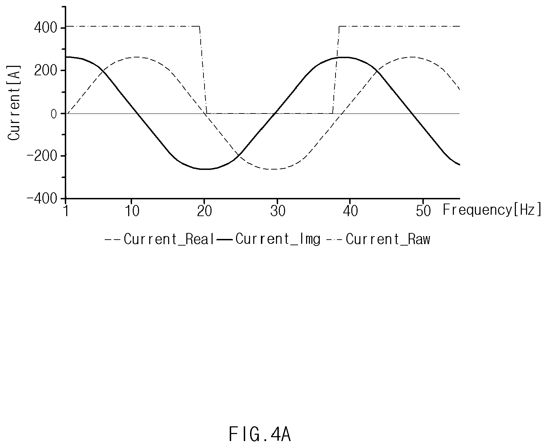

FIG. 4A is a graph showing a result of Fourier transform of a current value of a battery bank with respect to a flow of a time frequency, according to an embodiment disclosed herein.

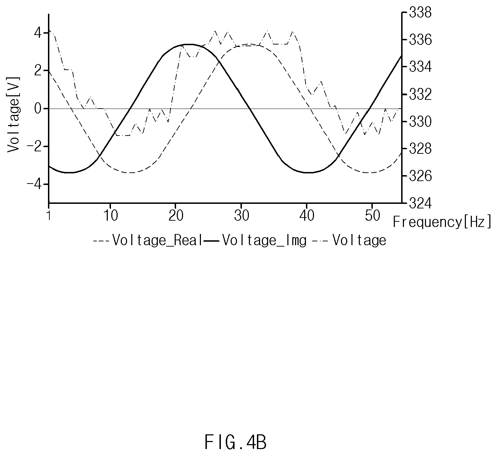

FIG. 4B is a graph showing a result of Fourier transform of a voltage value of a battery bank with respect to a flow of a time frequency, according to an embodiment disclosed herein.

Referring to FIGS. 4A and 4B, the controller 220 may perform Fourier transform (FT) on a voltage value and a current value of each of the plurality of battery banks 110, 120, 130, and 140 to obtain a real value and an imaginary value of the voltage value and the current value of each of the plurality of battery banks 110, 120, 130, and 140. Herein, Fourier transform may mean transform to decompose a function with respect to time or space into a time or space frequency component. The controller 220 may decompose a voltage value and a current value of each of the plurality of battery banks 110, 120, 130, and 140 over time into a time frequency component to convert the same into a complex number including a real value and an imaginary value. That is, the controller 220 may derive a waveform of a real value and an imaginary value of a voltage value and a current value of each of the plurality of battery banks 110, 120, 130, and 140 over time.

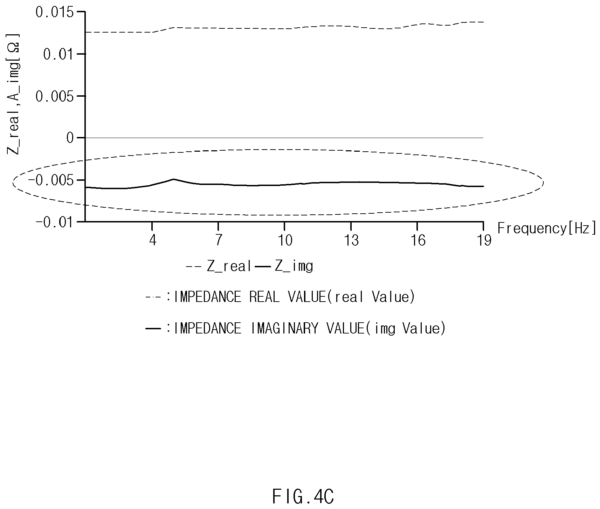

FIG. 4C is a graph showing a real value and an imaginary value of an impedance of a battery bank with respect to a flow of a time frequency, according to an embodiment disclosed herein.

Referring to FIG. 4C, the controller 220 may obtain an imaginary value of an impedance of each of the plurality of battery banks 110, 120, 130, and 140 based on a real value and an imaginary value of a voltage value and a current value of each of the plurality of battery banks 110, 120, 130, and 140. More specifically, the controller 220 may calculate an impedance based on the Ohm's Law used in the RLC current circuit.

In the RLC current circuit, the Ohm's Law is 'V = I*R', and when the Ohm's Law is extended to an alternating current circuit, it may be used as 'V = I*Z' or 'Z = V/I'. Herein, 'V' means a voltage, 'I' means a current, 'R' means a resistance, and 'Z' means an impedance. The impedance is a value that disturbs the flow of current when a voltage is applied to a circuit. The impedance value may be indicated by a ratio of a voltage V to a current I of an alternating current circuit in which the impedance has a value of a phase unlike a resistor used in the direct current circuit.

The controller 220 may separately calculate a real value and an imaginary value of an impedance of the plurality of battery banks 110, 120, 130, and 140 with respect to a change in a time frequency by inputting, to an equation 'Z = V/I', a real value and an imaginary value of a voltage value V and a current value I of each of the plurality of battery banks 110, 120, 130, and 140 with respect to a change in a time frequency. The imaginary value of the impedance of the plurality of battery banks 110, 120, 130, and 140 may change with a temperature of the battery bank. The imaginary value of the impedance of the battery bank may have a constant value in spite of the change in the time frequency, but may change with the temperature.

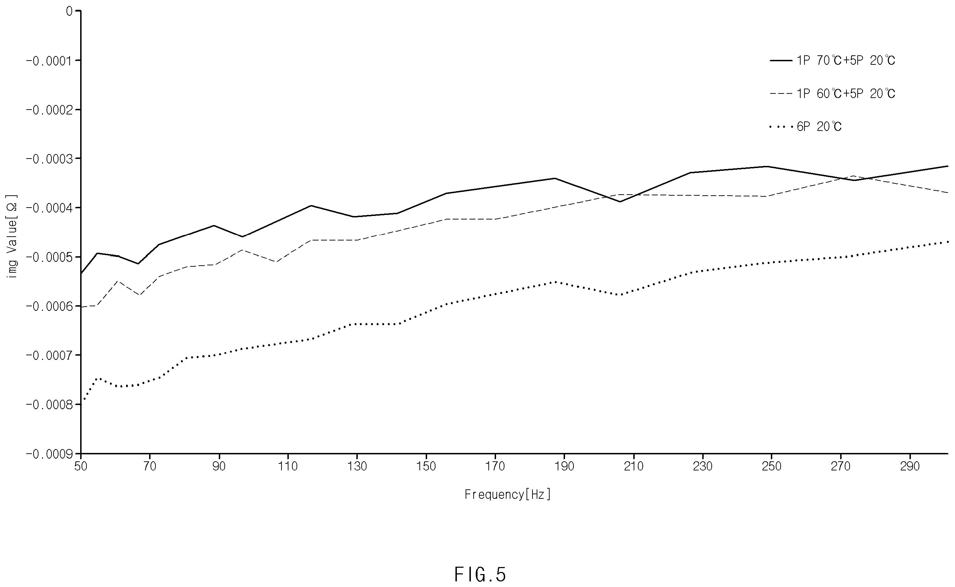

FIG. 5 is a graph showing a change in an imaginary value of an impedance a battery bank with respect to a change in a time frequency, according to an embodiment disclosed herein.

More specifically, the graph shown in FIG. 5 means a change of an imaginary value of an impedance of a battery bank including 6 battery cells 6P connected in parallel.

In FIG. 5, a graph shown as a dotted line at the bottom may show a change of the imaginary value of the impedance of the battery bank measured when all of the 6 battery cells are at 20 °C. The graph shown as a dotted line in the middle may show a change of the imaginary value of the impedance of the battery bank measured when one battery cell 1P is at 60 °C and the other 5 battery cells 5P are at 20 °C. The graph shown as a solid line may show a change of the imaginary value of the impedance of the battery bank measured when one battery cell 1P is at 70 °C and the other 5 battery cells 5P are at 20 °C.

Referring to FIG. 5, the controller 220 may diagnose a temperature change of a plurality of battery cells from a change of an imaginary value of an impedance of a plurality of battery banks. As shown in FIG. 5, the imaginary value of the alternating current impedance of the battery bank when heat generation occurs in one or more battery cell inside the battery bank may be distinguished from an imaginary value of an alternating current impedance of a battery bank including normal battery cells. The controller 220 may determine that heat generation occurs in any one of the plurality of battery cells inside the battery bank based on the imaginary value of the impedance of the battery bank.

For example, according to an embodiment, when the imaginary value of the impedance of any one of the plurality of battery banks 110, 120, 130, and 140 exceeds a previously stored threshold value, the controller 220 may determine that a heat-generated battery cell exists in at least any one of battery cells inside any one of the plurality of battery banks 110, 120, 130, and 140.

In addition, according to an embodiment, when the imaginary value of the impedance of any one of the plurality of battery banks 110, 120, 130, and 140 falls out of a threshold error range of an imaginary value of an impedance of another battery bank connected in series, the controller 220 may determine that a heat-generated battery cell exists in at least any one of battery cells inside any one of the plurality of battery banks 110, 120, 130, and 140.

As described above, the battery management apparatus 200 according to an embodiment disclosed herein may determine whether an abnormal battery cell exists inside a battery bank based on an impedance of the battery bank measured by a current and a voltage of the battery bank.

The battery management apparatus 200 may previously detect an abnormal battery cell inside a battery bank during an operation of the battery bank to prevent thermal runaway of the battery bank in advance.

When the abnormal battery cell is detected using a direct current resistance meter of an existing battery bank, the battery bank needs to be charged and discharged with a large current of 1C or more, a large equipment such as a cycler that is a large-size current charger is required, but the battery management apparatus 200 may generate an alternating current waveform through switching and apply the alternating current waveform to the battery bank, removing a need for a large-size equipment and thus reducing a cost.

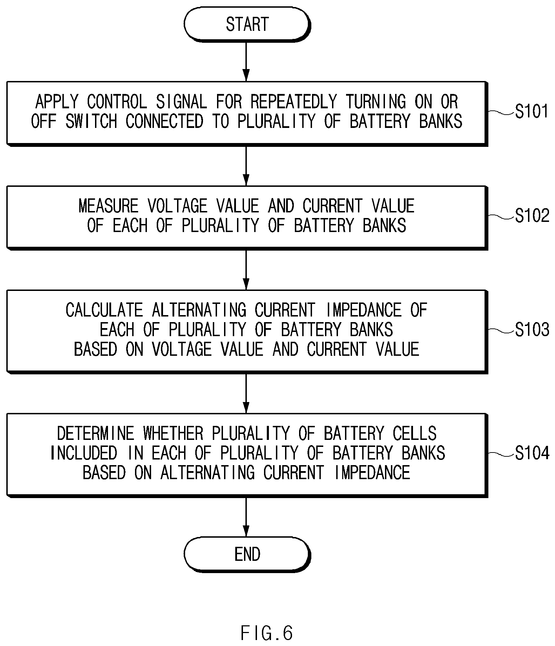

FIG. 6 is a flowchart showing an operating method of a battery management apparatus, according to an embodiment disclosed herein.

Referring to FIG. 6, an operating method of a battery management apparatus may include operation S101 of applying a control signal for repeatedly turning on or off the switch 210 connected to the plurality of battery banks 110, 120, 130, and 140 including a plurality of battery cells, operation S102 of measuring a voltage value and a current value of each of the plurality of battery banks 110, 120, 130, and 140, operation S103 of calculating an alternating current impedance of each of the plurality of battery banks 110, 120, 130, and 140 based on the voltage value and the current value, and operation S104 of determining whether the plurality of battery cells included in each of the plurality of battery banks 110, 120, 130, and 140 are abnormal based on the alternating current impedance of each of the plurality of battery banks 110, 120, 130, and 140.

In operation S101, the switch 210 may receive a control signal for repeatedly turning on and off the switch 210 from the controller 220. Herein, the switch 210 may be connected to a plurality of battery banks including a plurality of battery cells. The switch 210 may include, for example, an FET.

In operation S101, the switch 210 may be repeatedly turned on or off based on the control signal received from the controller 220. The switch 210 may be repeatedly turned on or off and deliver a current in an alternating current waveform to the plurality of battery banks 110, 120, 130, and 140.

In operation S101, the controller 220 may generate the control signal for repeatedly turning on and off the switch 210 and apply the control signal to the switch 210.

In operation S102, the controller 220 may measure a voltage value and a current value of each of the plurality of battery banks 110, 120, 130, and 140 having received the current in the alternating current waveform based on a switching operation of the switch 210.

In operation S103, the controller 220 may perform Fourier transform on a voltage value and a current value of each of the plurality of battery banks 110, 120, 130, and 140 to obtain a real value and an imaginary value of the voltage value and the current value of each of the plurality of battery banks 110, 120, 130, and 140. Herein, Fourier transform may mean transform to decompose a function with respect to time or space into a time or space frequency component.

In operation S103, the controller 220 may decompose a voltage value and a current value of each of the plurality of battery banks 110, 120, 130, and 140 over time into a time frequency component to convert the same into a complex number including a real value and an imaginary value. In operation S103, that is, the controller 220 may derive a waveform of a real value and an imaginary value of a voltage value and a current value of each of the plurality of battery banks 110, 120, 130, and 140 over time.

In operation S103, the controller 220 may obtain an imaginary value of an impedance of each of the plurality of battery banks 110, 120, 130, and 140 based on a real value and an imaginary value of a voltage value and a current value of each of the plurality of battery banks 110, 120, 130, and 140. In operation S103, the controller 220 may calculate an impedance based on the Ohm's Law used in the RLC current circuit. In operation S103, the controller 220 may calculate a real value and an imaginary value of an impedance of each of a plurality of battery cells inside the plurality of battery banks 110, 120, 130, and 140 with respect to a change in a time frequency by inputting, to the equation 'Z = V/I', a real value and an imaginary value of a voltage value V and a current value I of each of the plurality of battery cells inside the plurality of battery banks 110, 120, 130, and 140 with respect to a change in a time frequency.

In operation S104, the controller 220 may diagnose a temperature change of a plurality of battery cells from a change of an imaginary value of an impedance of a plurality of battery cells. The imaginary value of the alternating current impedance when heat generation occurs in one or more battery cell inside the battery bank may be distinguished from an imaginary value of an alternating current impedance of a battery bank including normal battery cells.

In operation S104, the controller 220 may determine that heat generation occurs in any one of the plurality of battery cells inside the battery bank based on the imaginary value of the impedance of the battery bank.

In operation S104, for example, according to an embodiment, when the imaginary value of the impedance of any one of the plurality of battery banks 110, 120, 130, and 140 exceeds a previously stored threshold value, the controller 220 may determine that a heat-generated battery cell exists in at least any one of battery cells inside any one of the plurality of battery banks 110, 120, 130, and 140.

In operation S104, in addition, according to an embodiment, when the imaginary value of the impedance of any one of the plurality of battery banks 110, 120, 130, and 140 falls out of a threshold error range of an imaginary value of an impedance of another battery bank connected in series, the controller 220 may determine that a heat-generated battery cell exists in at least any one of battery cells inside any one of the plurality of battery banks 110, 120, 130, and 140.

FIG. 6 is a block diagram showing a hardware configuration of a computing system to implement a battery management apparatus according to an embodiment disclosed herein.

Referring to FIG. 6, a computing system 2000 according to an embodiment disclosed herein may include an MCU 2100, a memory 2200, an input/output I/F 2300, and a communication I/F 2400.

The MCU 2100 may be a processor that executes various programs (e.g., an impedance calculation program of a battery bank, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

## Claims

1. A battery management apparatus (200) comprising:
a switch (210) connected to a plurality of battery banks (110, 120, 130, 140) comprising a plurality of battery cells; and
a controller (220) configured to apply a control signal for repeatedly turning on or off the switch, measuring a voltage value and a current value of each of the plurality of battery banks, and determine whether a plurality of battery cells included in each of the plurality of battery banks are abnormal based on an alternating current impedance of each of the plurality of battery banks calculated based on the voltage value and the current value,
**characterized in that** the controller is further configured to determine that heat is generated in at least any one of battery cells inside any one of the plurality of battery banks in an abnormal state when compared to a normal state of any one of the plurality of battery banks when an imaginary value of an impedance of any one of the plurality of battery banks exceeds a previously stored threshold value.

2. The battery management apparatus of claim 1, wherein the controller is further configured to obtain a real value and an imaginary value of the voltage value and the current value by performing Fourier transform on the voltage value and the current value of each of the plurality of battery banks.

3. The battery management apparatus of claim 2, wherein the controller is further configured to obtain an imaginary value of an impedance of each of the plurality of battery banks based on the real value and the imaginary value of the voltage value and the current value.

4. The battery management apparatus of claim 1, wherein the controller is further configured to determine that a heat-generated battery cell exists in at least any one of battery cells inside any one of the plurality of battery banks when an imaginary value of an impedance of any one of the plurality of battery banks falls beyond a threshold error range of an imaginary value of an impedance of a battery bank serially connected to any one of the plurality of battery banks.

5. An operating method of a battery management apparatus, the operating method:
applying (S101) a control signal for repeatedly turning on or off a switch connected to a plurality of battery banks comprising a plurality of battery cells;
measuring (S102) a voltage value and a current value of each of the plurality of battery banks;
calculating (S103) an alternating current impedance of each of the plurality of battery banks based on the voltage value and the current value; and
determining (S104) whether a plurality of battery cells included in each of the plurality of battery banks are abnormal based on an alternating current impedance of each of the plurality of battery banks,
wherein the determining of whether the plurality of battery cells included in each of the plurality of battery banks are abnormal based on an alternating current impedance of each of the plurality of battery banks comprises determining that heat is generated in at least any one of battery cells inside any one of the plurality of battery banks in an abnormal state when compared to a normal state of any one of the plurality of battery banks when an imaginary value of an impedance of any one of the plurality of battery banks exceeds a previously stored threshold value.

6. The operating method of claim 5, wherein the calculating of the alternating current impedance of each of the plurality of battery banks based on the voltage value and the current value comprises obtaining a real value and an imaginary value of the voltage value and the current value by performing Fourier transform on the voltage value and the current value of each of the plurality of battery banks.

7. The operating method of claim 6, wherein the calculating of the alternating current impedance of each of the plurality of battery banks based on the voltage value and the current value comprises obtaining an imaginary value of an impedance of each of the plurality of battery banks based on the real value and the imaginary value of the voltage value and the current value.

8. The operating method of claim 5, wherein the determining of whether the plurality of battery cells included in each of the plurality of battery banks are abnormal based on an alternating current impedance of each of the plurality of battery banks comprises determining that a heat-generated battery cell exists in at least any one of battery cells inside any one of the plurality of battery banks when an imaginary value of an impedance of any one of the plurality of battery banks falls beyond a threshold error range of an imaginary value of an impedance of a battery bank serially connected to any one of the plurality of battery banks.

## Patentansprüche

1. Batteriemanagementvorrichtung (200), umfassend:
einen Schalter (210), der mit einer Vielzahl von Batteriebänken (110, 120, 130, 140) verbunden ist, die eine Vielzahl von Batteriezellen umfassen; und
eine Steuerung (220), die dafür ausgelegt ist, ein Steuersignal zum wiederholten Ein- oder Ausschalten des Schalters anzulegen, einen Spannungswert und einen Stromwert jeder der Vielzahl von Batteriebänken zu messen und zu bestimmen, ob eine Vielzahl von Batteriezellen, die in jeder der Vielzahl von Batteriebänken enthalten sind, anormal sind, basierend auf einer Wechselstromimpedanz jeder der Vielzahl von Batteriebänken, die basierend auf dem Spannungswert und dem Stromwert berechnet wird,
**dadurch gekennzeichnet, dass** die Steuerung ferner dafür ausgelegt ist, zu bestimmen, dass in mindestens einer beliebigen der Batteriezellen innerhalb einer beliebigen der Vielzahl von Batteriebänken in einem anormalen Zustand im Vergleich zu einem normalen Zustand einer beliebigen der Vielzahl von Batteriebänken Wärme erzeugt wird, wenn ein Imaginärwert einer Impedanz einer beliebigen der Vielzahl von Batteriebänken einen zuvor gespeicherten Schwellenwert überschreitet.

2. Batteriemanagementvorrichtung nach Anspruch 1, wobei die Steuerung ferner dafür ausgelegt ist, einen Realwert und einen Imaginärwert des Spannungswerts und des Stromwerts durch Durchführen einer Fourier-Transformation an dem Spannungswert und dem Stromwert jeder der Vielzahl von Batteriebänken zu erhalten.

3. Batteriemanagementvorrichtung nach Anspruch 2, wobei die Steuerung ferner dafür ausgelegt ist, einen Imaginärwert einer Impedanz jeder der Vielzahl von Batteriebänken basierend auf dem Realwert und dem Imaginärwert des Spannungswerts und des Stromwerts zu erhalten.

4. Batteriemanagementvorrichtung nach Anspruch 1, wobei die Steuerung ferner dafür ausgelegt ist, zu bestimmen, dass eine wärmeerzeugte Batteriezelle in mindestens einer beliebigen der Batteriezellen innerhalb einer beliebigen der Vielzahl von Batteriebänken vorhanden ist, wenn ein Imaginärwert einer Impedanz einer beliebigen der Vielzahl von Batteriebänken außerhalb eines Schwellenwertfehlerbereichs eines Imaginärwerts einer Impedanz einer Batteriebank liegt, die mit einer beliebigen der Vielzahl von Batteriebänken in Reihe geschaltet ist.

5. Betriebsverfahren einer Batteriemanagementvorrichtung, wobei das Betriebsverfahren:
Anlegen (S101) eines Steuersignals zum wiederholten Ein- oder Ausschalten eines Schalters, der mit einer Vielzahl von Batteriebänken verbunden ist, die eine Vielzahl von Batteriezellen umfassen;
Messen (S102) eines Spannungswerts und eines Stromwerts jeder der Vielzahl von Batteriebänken;
Berechnen (S103) einer Wechselstromimpedanz jeder der Vielzahl von Batteriebänken basierend auf dem Spannungswert und dem Stromwert; und
Bestimmen (S104), ob eine Vielzahl von Batteriezellen, die in jeder der Vielzahl von Batteriebänken enthalten sind, anormal sind, basierend auf einer Wechselstromimpedanz jeder der Vielzahl von Batteriebänken,
wobei das Bestimmen, ob die Vielzahl von Batteriezellen, die in jeder der Vielzahl von Batteriebänken enthalten sind, anormal sind, basierend auf einer Wechselstromimpedanz jeder der Vielzahl von Batteriebänken, das Bestimmen umfasst, dass in mindestens einer beliebigen der Batteriezellen innerhalb einer beliebigen der Vielzahl von Batteriebänken in einem anormalen Zustand im Vergleich zu einem normalen Zustand einer beliebigen der Vielzahl von Batteriebänken Wärme erzeugt wird, wenn ein Imaginärwert einer Impedanz einer beliebigen der Vielzahl von Batteriebänken einen zuvor gespeicherten Schwellenwert überschreitet.

6. Betriebsverfahren nach Anspruch 5, wobei das Berechnen der Wechselstromimpedanz jeder der Vielzahl von Batteriebänken basierend auf dem Spannungswert und dem Stromwert das Erhalten eines Realwerts und eines Imaginärwerts des Spannungswerts und des Stromwerts durch Durchführen einer Fourier-Transformation an dem Spannungswert und dem Stromwert jeder der Vielzahl von Batteriebänken umfasst.

7. Betriebsverfahren nach Anspruch 6, wobei das Berechnen der Wechselstromimpedanz jeder der Vielzahl von Batteriebänken basierend auf dem Spannungswert und dem Stromwert das Erhalten eines Imaginärwerts einer Impedanz jeder der Vielzahl von Batteriebänken basierend auf dem Realwert und dem Imaginärwert des Spannungswerts und des Stromwerts umfasst.

8. Betriebsverfahren nach Anspruch 5, wobei das Bestimmen, ob die Vielzahl von Batteriezellen, die in jeder der Vielzahl von Batteriebänken enthalten sind, anormal sind, basierend auf einer Wechselstromimpedanz jeder der Vielzahl von Batteriebänken, das Bestimmen umfasst, dass eine wärmeerzeugte Batteriezelle in mindestens einer beliebigen der Batteriezellen innerhalb einer beliebigen der Vielzahl von Batteriebänken vorhanden ist, wenn ein Imaginärwert einer Impedanz einer beliebigen aus der Vielzahl von Batteriebänken außerhalb eines Schwellenwertfehlerbereichs eines Imaginärwerts einer Impedanz einer Batteriebank liegt, die mit einer beliebigen der Vielzahl von Batteriebänken in Reihe geschaltet ist.

## Revendications

1. Appareil de gestion de batterie (200) comprenant :
un commutateur (210) connecté à une pluralité de bancs de batteries (110, 120, 130, 140) comprenant une pluralité de cellules de batterie ; et
un contrôleur (220) configuré pour appliquer un signal de commande pour mettre en marche ou arrêter de manière répétée le commutateur, mesurer une valeur de tension et une valeur de courant de chacun de la pluralité de bancs de batteries, et déterminer si une pluralité de cellules de batterie incluses dans chacun de la pluralité de bancs de batteries sont anormales sur la base d'une impédance en courant alternatif de chacun de la pluralité de bancs de batteries calculée sur la base de la valeur de tension et de la valeur de courant,
**caractérisé en ce que** le contrôleur est en outre configuré pour déterminer que de la chaleur est générée dans au moins l'une quelconque des cellules de batterie à l'intérieur de l'un quelconque de la pluralité de bancs de batteries dans un état anormal par rapport à un état normal de l'un quelconque de la pluralité de bancs de batteries lorsqu'une valeur imaginaire d'une impédance de l'un quelconque de la pluralité de bancs de batteries dépasse une valeur de seuil précédemment stockée.

2. Appareil de gestion de batterie selon la revendication 1, dans lequel le contrôleur est en outre configuré pour obtenir une valeur réelle et une valeur imaginaire de la valeur de tension et de la valeur de courant en effectuant une transformée de Fourier sur la valeur de tension et la valeur de courant de chacun de la pluralité de bancs de batteries.

3. Appareil de gestion de batterie selon la revendication 2, dans lequel le contrôleur est en outre configuré pour obtenir une valeur imaginaire d'une impédance de chacun de la pluralité de bancs de batteries sur la base de la valeur réelle et de la valeur imaginaire de la valeur de tension et de la valeur de courant.

4. Appareil de gestion de batterie selon la revendication 1, dans lequel le contrôleur est en outre configuré pour déterminer qu'une cellule de batterie générant de la chaleur existe dans au moins l'une quelconque des cellules de batterie à l'intérieur de l'un quelconque de la pluralité de bancs de batteries lorsqu'une valeur imaginaire d'une impédance de l'un quelconque de la pluralité de bancs de batteries tombe au-delà d'une plage d'erreur de seuil d'une valeur imaginaire d'une impédance d'un banc de batteries connecté en série à l'un quelconque de la pluralité de bancs de batteries.

5. Procédé de fonctionnement d'un appareil de gestion de batterie, le procédé de fonctionnement consistant à :
appliquer (S101) un signal de commande pour mettre en marche ou arrêter de manière répétée un commutateur connecté à une pluralité de bancs de batteries comprenant une pluralité de cellules de batterie ;
mesurer (S102) une valeur de tension et une valeur de courant de chacun de la pluralité de bancs de batteries ;
calculer (S103) une impédance en courant alternatif de chacun de la pluralité de bancs de batteries sur la base de la valeur de tension et de la valeur de courant ; et
déterminer (S104) si une pluralité de cellules de batterie incluses dans chacun de la pluralité de bancs de batteries sont anormales sur la base d'une impédance en courant alternatif de chacun de la pluralité de bancs de batteries,
dans lequel la détermination si la pluralité de cellules de batterie incluses dans chacun de la pluralité de bancs de batteries sont anormales sur la base d'une impédance en courant alternatif de chacun de la pluralité de bancs de batteries comprend la détermination que de la chaleur est générée dans au moins l'une quelconque des cellules de batterie à l'intérieur de l'un quelconque de la pluralité de bancs de batteries dans un état anormal par rapport à un état normal de l'un quelconque de la pluralité de bancs de batteries lorsqu'une valeur imaginaire d'une impédance de l'un quelconque de la pluralité de bancs de batteries dépasse une valeur de seuil précédemment stockée.

6. Procédé de fonctionnement selon la revendication 5, dans lequel le calcul de l'impédance en courant alternatif de chacun de la pluralité de bancs de batteries sur la base de la valeur de tension et de la valeur de courant comprend l'obtention d'une valeur réelle et d'une valeur imaginaire de la valeur de tension et de la valeur de courant en effectuant une transformée de Fourier sur la valeur de tension et la valeur de courant de chacun de la pluralité de bancs de batteries.

7. Procédé de fonctionnement selon la revendication 6, dans lequel le calcul de l'impédance en courant alternatif de chacun de la pluralité de bancs de batteries sur la base de la valeur de tension et de la valeur de courant comprend l'obtention d'une valeur imaginaire d'une impédance de chacun de la pluralité de bancs de batteries sur la base de la valeur réelle et de la valeur imaginaire de la valeur de tension et de la valeur de courant.

8. Procédé de fonctionnement selon la revendication 5, dans lequel la détermination si la pluralité de cellules de batterie incluses dans chacun de la pluralité de bancs de batteries sont anormales sur la base d'une impédance en courant alternatif de chacun de la pluralité de bancs de batteries comprend la détermination qu'une cellule de batterie générant de la chaleur existe dans au moins l'une quelconque des cellules de batterie à l'intérieur de l'un quelconque de la pluralité de bancs de batteries lorsqu'une valeur imaginaire d'une impédance de l'un quelconque de la pluralité de bancs de batteries tombe au-delà d'une plage d'erreur de seuil d'une valeur imaginaire d'une impédance d'un banc de batteries connecté en série à l'un quelconque de la pluralité de bancs de batteries.
